(19)

Europäisches
Patentamt

European
Patent Office

Office européen
des brevets

(11) **EP 3 813 218 A1**

(12) **EUROPÄISCHE PATENTANMELDUNG**

(43) Veröffentlichungstag:
**28.04.2021 Patentblatt 2021/17**

(51) Int Cl.:
*H02J 3/18* (2006.01) *F03D 9/25* (2016.01)
*H02J 3/38* (2006.01)

(21) Anmeldenummer: **20201076.5**

(22) Anmeldetag: **09.10.2020**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME
KH MA MD TN**

(30) Priorität: **25.10.2019 DE 102019128811**

(71) Anmelder: **Wobben Properties GmbH
26607 Aurich (DE)**

(72) Erfinder:
• **Bartsch, Matthias
28215 Bremen (DE)**
• **Strafiel, Christian
26607 Aurich (DE)**

(74) Vertreter: **Eisenführ Speiser
Patentanwälte Rechtsanwälte PartGmbB
Postfach 10 60 78
28060 Bremen (DE)**

(54) **VERFAHREN ZUM EINSPEISEN ELEKTRISCHER LEISTUNG IN EIN ELEKTRISCHES VERSORGUNGSNETZ**

(57)    Die Erfindung betrifft ein Verfahren zum Einspeisen elektrischer Leistung in ein elektrisches, dreiphasiges Versorgungsnetz mittels einer Wechselrichtereinrichtung (105, 204), wobei das elektrische Versorgungsnetz (208) eine dreiphasige Netzspannung mit einer ersten, zweiten und dritten Netzspannungsphase aufweist, umfassend die Schritte: Einspeisen der elektrischen Leistung in einem Normalbetrieb, wenn für das elektrische Versorgungsnetz (208) ein störungsfreier Betrieb erkannt wurde, wobei im Normalbetrieb von der Netzspannung eine Mitsystemspannung ($u^+$) und optional eine Gegensystemspannung ($u^-$) erfasst wird und ein Blindstrom wenigstens in Abhängigkeit von der Mitsystemspannung ($u^+$) und optional in Abhängigkeit von der Gegensystemspannung ($u^-$) vorgegeben wird, und Wechseln in einen Störungsbetrieb, wenn eine Spannungsveränderung der Netzspannung ein vorbestimmtes Störungskriterium erfüllt, insbesondere wenn die Spannungsveränderung einen vorgebbaren Mindeständerungsbetrag oder Mindeständerungsgradientenbetrag überschreitet, wobei im Störungsbetrieb, zumindest unmittelbar nach dem Wechsel, der Blindstrom in Abhängigkeit von einer Raumzeigerspannung ($\vec{u}$) vorgegeben wird.

Fig. 2

EP 3 813 218 A1

**Beschreibung**

Die vorliegende Erfindung betrifft ein Verfahren zum Einspeisen elektrischer Leistung in ein elektrisches, dreiphasiges Versorgungsnetz mittels einer Wechselrichtereinrichtung. Insbesondere betrifft die vorliegende Erfindung ein solches Verfahren unter Verwendung einer Windenergieanlage. Die Erfindung betrifft außerdem eine Windenergieanlage mit einer Wechselrichtereinrichtung zum Einspeisen elektrischer Leistung in ein elektrisches, dreiphasiges Versorgungsnetz.

Besonders Windenergieanlagen und Photovoltaikanlagen, aber auch andere dezentrale Einspeiseeinheiten speisen regelmäßig mittels einem oder mehrerer Wechselrichter in das elektrische Versorgungsnetz ein. Meist werden mehrere Wechselrichter verwendet und diese können zusammen eine Wechselrichtereinrichtung bilden, oder einen Teil davon. Solche dezentralen Einspeiser müssen häufig auch Blindleistung in das elektrische Versorgungsnetz einspeisen können. Dabei kann für die Einspeisung von Blindleistung vorgesehen sein, dass im Sinne der Methode der symmetrischen Komponenten eine Einspeisung des entsprechenden Blindstroms im Mit- und Gegensystem vorgenommen wird, zumindest im Mitsystem. Das kann auch eine Vorschrift des elektrischen Versorgungsnetzes bzw. seines Betreibers sein.

Die Bestimmung der Mit- und Gegensystemspannungen im elektrischen Versorgungsnetz wird hierfür benötigt. Eine solche Bestimmung der Mit- und Gegensystemspannungen kann dabei ein vergleichsweise langsamer Vorgang sein, jedenfalls gemessen an teilweise im elektrischen Versorgungsnetz einzuhaltenden kurzen Reaktionszeiten.

Ändert sich also die Netzspannung, besonders auf Grund eines Fehlers, so ist die Bestimmung der Mit- und Gegensystemspannungen mitunter nicht schnell genug, sodass diese Spannungsänderung nicht ausreichend schnell erfasst wird, bzw. nach kurzer Zeit noch nicht genau genug erfasst ist. Besonders ist die Mit- und Gegensystemspannung regelmäßig nur über die Dauer einer Periode der Netzspannung erfassbar. Im Falle eines 50 Hz-Netzes werden somit wenigstens 20ms benötigt, um die Änderungen der Netzspannung zu erfassen.

Entsprechend kann auch der Anstieg der daraus abgeleiteten Blindstromeinspeisung nur vergleichsweise langsam erfolgen. Besonders bei einer spannungsabhängigen Blindstromeinspeisung, bei der also die Amplitude des eingespeisten Blindstroms bzw. die Amplitude der eingespeisten Blindleistung, von der Netzspannung abhängt, kann die Blindleistungseinspeisung einer Spannungsänderung nicht schnell genug nachgeführt werden. Mit anderen Worten kommt es vor, dass der Anstieg der aus der Netzspannung abgeleiteten Blindstromeinspeisung zu langsam erfolgt.

Das Deutsche Patent- und Markenamt hat in der Prioritätsanmeldung zu vorliegender Anmeldung folgenden Stand der Technik recherchiert: DE 197 34 722 A1, DE 10 2015 112 155 A1 und CA 2 300 306 A1.

Der vorliegenden Erfindung liegt somit die Aufgabe zugrunde, zumindest eins der vorstehend genannten Probleme zu adressieren. Insbesondere soll eine Lösung vorgeschlagen werden, die möglichst eine Einspeisung eines Blindstroms im Mit- und Gegensystem durchführt und dennoch möglichst schnell eine Blindleistungsnachführung im Falle einer schnellen Spannungsänderung der Netzspannung ermöglicht. Zumindest soll zu bisher bekannten Lösungen eine alternative Lösung vorgeschlagen werden.

Erfindungsgemäß wird ein Verfahren gemäß Anspruch 1 vorgeschlagen. Demnach wird ein Verfahren vorgeschlagen zum Einspeisen elektrischer Leistung in ein elektrisches, dreiphasiges Versorgungsnetz mittels einer Wechselrichtereinrichtung. Insbesondere kann die Wechselrichtereinrichtung einen oder mehrere Wechselrichter umfassen, oder sie kann ein Wechselrichter sein. Vorzugsweise ist die Wechselrichtereinrichtung Teil eines dezentralen Einspeisers, wie eine Windenergieanlage, ein Windpark oder eine Photovoltaikanlage.

Das elektrische Versorgungsnetz weist eine dreiphasige Netzspannung auf mit einer ersten, zweiten und dritten Netzspannungsphase. Das Verfahren zum Einspeisen ist somit auf dieses dreiphasige Versorgungsnetz abgestimmt. Die drei Netzspannungsphasen werden gemeinsam betrachtet.

Es ist weiter vorgesehen, dass das Verfahren die elektrische Leistung in einem Normalbetrieb, wenn für das elektrische Versorgungsnetz ein störungsfreier Betrieb erkannt wurde, eingespeist wird. In diesem Normalbetrieb wird von der Netzspannung eine Mitsystemspannung und optional eine Gegensystemspannung erfasst, und ein Blindstrom wird wenigstens in Abhängigkeit von der Mitsystemspannung und optional in Abhängigkeit von der Gegensystemspannung vorgegeben. Es wird somit eine Zerlegung der dreiphasigen Netzspannung nach der Methode der symmetrischen Komponenten vorgeschlagen. Das Ergebnis einer solchen Zerlegung ist grundsätzlich eine Mitsystemkomponente, eine Gegensystemkomponente und eine Gleichanteilkomponente. Wie häufig, so kommt es auch hier nicht auf die Gleichanteilkomponente an, sondern auf die Mitsystemkomponente und die Gegensystemkomponente. Es kann dabei ausreichen, die Mitsystemkomponente zu betrachten. Auch, wenn nur die Mitsystemkomponente, also die Mitsystemspannung, berücksichtigt wird, so wird dadurch aber in jedem Fall eine Gesamtbetrachtung der dreiphasigen Netzspannung durchgeführt.

Der Blindstrom, der in Abhängigkeit von der Mitsystemspannung eingespeist wird, wird somit ebenfalls dreiphasig vorgesehen und eingespeist. Der Blindstrom kann dabei insoweit von der Mitsystemspannung abhängen, als dass ihre Amplitude, insbesondere ein Effektivwert der Mitsystemspannung berücksichtigt wird. Besonders kann eine Abweichung dieser Amplitude von einer Referenzspannung betrachtet werden und abhängig von dieser Abweichung die Amplitude des einzuspeisenden Blindstroms bestimmt werden.

Weiterhin wird vorgeschlagen, in einen Störungsbetrieb zu wechseln, wenn eine Spannungsveränderung der Netzspannung ein vorbestimmtes Störungskriterium erfüllt. Insbesondere wenn die Spannungsveränderung einen vorgebbaren Mindeständerungsbetrag oder Mindeständerungsgradientenbetrag überschreitet. Es wird somit ausdrücklich ein Störungsbetrieb berücksichtigt. Dieser kann dadurch erkannt werden und damit auch dadurch definiert werden, dass eine Spannungsveränderung der Netzspannung ein vorbestimmtes Störungskriterium erfüllt. Es wird also die Netzspannung auf das Vorliegen einer Störung untersucht. Von einer Störung ist besonders dann auszugehen, wenn die Spannungsveränderung einen vorgebbaren Mindeständerungsbetrag überschreitet. Wenn die Spannungsänderung also größer ist als ein vorbestimmter Grenzwert, liegt der Störungsbetrieb vor. Statt einer absoluten Änderung kann auch eine Änderungsgeschwindigkeit, also ein Änderungsgradient der Spannung betrachtet werden. Dafür kann ein Mindeständerungsgradientenbetrag als Schwelle zugrunde gelegt werden. Insbesondere liegt ein Störungsbetrieb vor, wenn die Netzspannung einbricht. Entsprechend liegt per Definition dann ein Normalbetrieb vor, wenn kein Störungsbetrieb erfasst oder erkannt wurde.

Es wird nun vorgeschlagen, dass im Störungsbetrieb, zumindest unmittelbar nach dem Wechsel vom Normalbetrieb in den Störungsbetrieb, der Blindstrom in Abhängigkeit von einer Raumzeigerspannung vorgegeben wird.

Eine Raumzeigerspannung ist dem Fachmann geläufig und berechnet sich ebenfalls aus den drei Netzspannungsphasen. Eine Raumzeigerspannung ist dabei ein mit der Zeit in der komplexen Ebene umlaufender Spannungszeiger, der auch als Raumzeiger oder Raumzeigerspannung bezeichnet werden kann. Eine solche Raumzeigerspannung unterscheidet allerdings nicht zwischen symmetrischem und asymmetrischem Anteil der drei Netzspannungsphasen.

Insbesondere wird vorgeschlagen, dass die Raumzeigerspannung $\vec{u}$, definiert ist durch die Gleichung

$$\vec{u} = \left[ u_1 + u_2 \exp\left( j\frac{2}{3}\pi \right) + u_3 \exp\left( j\frac{4}{3}\pi \right) \right],$$

mit $u_1$, $u_2$ und $u_3$ jeweils als Augenblickswert, insbesondere als momentaner Messwert der ersten, zweiten bzw. dritten Netzspannungsphase.

Es fließen also alle drei Netzspannungsphasen ein und es kann ein Wert der Raumzeigerspannung aus den drei Augenblickswerten der drei Netzspannungsphasen sofort berechnet werden. Die Raumzeigerspannung liegt also sehr schnell vor und kann daher schneller einen Spannungswert liefern als die Mitsystemspannung. Es wird durch den Wechsel somit für die Bestimmung des Blindstroms von einer Referenzierung auf die Mitsystemspannung auf eine Referenzierung auf die Raumzeigerspannung gewechselt.

Es wird also vorgeschlagen, dass zumindest unmittelbar nach dem Wechsel vom Normalbetrieb in den Störungsbetrieb auf die Referenzierung auf die Raumzeigerspannung gewechselt wird. Hier wurde besonders erkannt, dass die Blindleistungseinspeisung schnell auf die Störung, die auch als Fehler bezeichnet werden kann, reagieren sollte. Dafür wird der Wechsel der Referenzierung vorgeschlagen. Nach dieser schnellen Reaktion kann auch bei Fortbestehen der Störung bzw. des Fehlers auf die Referenzierung auf die Mitsystemspannung zurückgewechselt werden. Besonders wurde erkannt, dass der Übergang beim Auftreten des Fehlers kritisch ist und dann schnell reagiert werden muss. Besteht die Störung bzw. der Fehler fort, ohne aber starke Änderungen hervorzurufen, kann die Referenzierung auf die Mitsystemspannung ausreichend oder sogar besser geeignet sein.

Gemäß einer Ausführungsform wird vorgeschlagen, dass die Raumzeigerspannung auch im Normalbetrieb ständig bestimmt wird und abhängig von der erfassten Raumzeigerspannung der Störungsbetrieb erkannt wird. Hier liegt auch die Erkenntnis zugrunde, dass die Raumzeigerspannung schneller erfasst werden kann bzw. schneller Änderungen der Netzspannung wiederspiegelt. Vorzugsweise werden zwar im Normalbetrieb die Einspeisung und auch die Blindleistungseinspeisung abhängig der Mitsystemspannung gesteuert, die Erfassung der Raumzeigerspannung kann aber mitlaufen, ohne dass sie die Steuerung beeinflussen muss. Die Raumzeigerspannung, die somit im Normalbetrieb ständig bestimmt wird, kann dann insoweit ausgewertet werden, ob ein Übergang zum Störungsbetrieb vorliegt. Dadurch kann ein Störungsbetrieb schnell erkannt werden.

Gemäß einer Ausführungsform wird vorgeschlagen, dass das Vorgeben des Blindstroms in Abhängigkeit von der Raumzeigerspannung zurück in das Vorgeben des Blindstroms in Abhängigkeit von der Mitsystemspannung übergeht, wenn die Mitsystemspannung im Wesentlichen einen stationären Wert angenommen hat und/oder wenn Änderungen der Mitsystemspannung dem Betrage nach unterhalb eines vorgebbaren Grenzgradienten liegen. Somit wird, was auch für die übrigen Ausführungsformen als mögliches Merkmal vorgeschlagen wird, die Mitsystemspannung während des Störungsbetriebs weiter erfasst. Insbesondere wird unabhängig davon, ob der Normalbetrieb oder der Störungsbetrieb vorliegt, die Mitsystemspannung weiter erfasst. Ändert sich die Mitsystemspannung dem Betrage nach wenig, so kann davon ausgegangen werden, dass ein Normalbetrieb vorliegt bzw. der Störungsbetrieb vorüber ist. Zur Beurteilung, ob die Mitsystemspannung sich nur wenig ändert, wird vorgeschlagen, einen Grenzgradienten vorzugeben. Der kann auch als Grenzgradient für Änderungen der Mitsystemspannung bezeichnet werden. Vorzugsweise beträgt dieser Grenzgradient dem Betrage nach 3% bis 5% der Nennspannung pro Periodendauer.

Hierbei wird auch berücksichtigt, dass die Mitsystemspannung systembedingt durch die Art ihrer Erfassung weniger Rauschen aufweist, als die Raumzeigerspannung. Daher ist die Mitsystemspannung gut geeignet, auf einen Gradienten geprüft zu werden.

Es wurde auch erkannt, dass das Wechseln von dem Normalbetrieb in den Störungsbetrieb zeitkritisch ist und vorzugsweise abhängig der Raumzeigerspannung durchgeführt wird, die Spannungsänderungen schneller erkennen lässt, als die Mitsystemspannung. Gleichzeitig wurde erkannt, dass das Zurückwechseln in den Normalbetrieb weniger zeitkritisch ist und damit die Mitsystemspannung als Kriterium gut verwendet werden kann.

Es wird daher gemäß einer Ausführungsform vorgeschlagen, dass von dem Normalbetrieb in den Störungsbetrieb in Abhängigkeit der Raumzeigerspannung gewechselt wird, wohingegen von dem Störungsbetrieb zurück in den Normalbetrieb in Abhängigkeit von der Mitsystemspannung gewechselt wird.

Gemäß einer Ausführungsform wird vorgeschlagen, dass das Vorgeben des Blindstroms in Abhängigkeit von der Raumzeigerspannung zurück in das Vorgeben des Blindstroms in Abhängigkeit von der Mitsystemspannung übergeht, wenn die Raumzeigerspannung im Falle eines Spannungseinbruchs einer oder mehrerer Netzspannungsphasen einen Minimalwert erreicht hat. Es wird also davon ausgegangen, dass sich eine Netzstörung als Spannungseinbruch bemerkbar macht bzw. ein Spannungseinbruch ist. Weiter wurde erkannt, dass das Referenzieren auf die Raumzeigerspannung nur für einen kurzen Übergangsbereich benötigt wird. Hierbei bricht auch die Raumzeigerspannung schnell ein und führt zu einem entsprechend steigenden Blindstrom, der abhängig der Raumzeigerspannung berechnet wird. Die Raumzeigerspannung kann, besonders wenn nicht alle Spannungsphasen einbrechen, einen mit der Netzfrequenz oszillierenden Verlauf aufweisen und es ist dann an erster Stelle wichtig, schnell durch die Blindleistung eine schnelle Stützung zu erreichen. Danach kann dann die Blindleistung genauer eingestellt werden, und dafür kann auch wieder die Mitsystemspannung verwendet werden.

Gemäß einer Variante wird vorgeschlagen, dass das Vorgeben des Blindstroms in Abhängigkeit von der Raumzeigerspannung zurück in das Vorgeben des Blindstroms in Abhängigkeit von der Mitsystemspannung übergeht, wenn ein Verlauf der Raumzeigerspannung eine Wendestelle erreicht hat. Sind die Spannungsphasen nach einer Störung, besonders einem Spannungseinbruch nicht mehr symmetrisch, weil z.B. nicht alle Spannungsphasen einbrechen, kann die Raumzeigerspannung weiterhin oszillieren. Für die Berechnung der Blindleistung kann ein Mittelwert dieser oszillierenden Raumzeigerspannung von Bedeutung sein und einen solchen Mittelwert erreicht die Raumzeigerspannung etwa bei ihrer Wendestelle, wenn ihr Spannungsabfall also dem Betrage nach ein Maximum erreicht hat.

Gemäß einer Variante wird vorgeschlagen, dass das Vorgeben des Blindstroms in Abhängigkeit von der Raumzeigerspannung zurück in das Vorgeben des Blindstroms in Abhängigkeit von der Mitsystemspannung übergeht, wenn eine vorbestimmte Übergangszeit nach Erkennen des Störungsbetriebs verstrichen ist. Hier wurde besonders erkannt, dass eine solche Übergangszeit, die im Bereich von einem Viertel einer Netzperiode liegen kann, vorausberechnet werden kann und dadurch noch schneller reagiert werden kann. Es kann also ohne Auswertung der Messungen in die Referenzierung abhängig der Mitsystemspannung zurückgewechselt werden.

Gemäß einer Ausführungsform wird vorgeschlagen, dass ab dem Wechseln in den Störungsbetrieb das Vorgeben des Blindstroms in Abhängigkeit von der Raumzeigerspannung erfolgt, bis ein Rückschaltkriterium erkannt wurde, bei Erkennen des Rückschaltkriteriums der Blindstromwert, der in Abhängigkeit von der Raumzeigerspannung berechnet wurde, als Raumzeigerblindstromwert gehalten wird, ab Erkennen des Rückschaltkriteriums kontinuierlich ein Mitsystemblindstromwert in Abhängigkeit der Mitsystemspannung berechnet wird, und der vorgegebene Blindstrom dadurch berechnet wird, dass der gehaltene Raumzeigerblindstromwert in den Mitsystemblindstromwert über einen vorgebbaren Übergangsverlauf übergeht.

Der Blindstrom wird somit zu Beginn des Störungsbetriebs zunächst nur in Abhängigkeit von der Raumzeigerspannung berechnet, bis das Rückschaltkriterium eintritt bzw. erkannt wurde. Das Rückhaltekriterium kann bspw. sein, dass die Raumzeigerspannung im Falle eines Spannungseinbruchs einer oder mehrerer Netzspannungsphasen einen Minimalwert erreicht, oder dass ein Verlauf der Raumzeigerspannung eine Wendestelle erreicht hat, oder es kann der Ablauf der vorbestimmten Übergangszeit sein.

Wird dieses Kriterium erreicht, wird der letzte Blindstromwert, der in Abhängigkeit der Raumzeigerspannung berechnet wurde, quasi eingefroren. Von ihm aus wird dann zu dem Blindstromwert übergegangen, der sich aus der Mitsystemspannung berechnet. Das kann auch als Überblenden bezeichnet werden und es kann sinngemäß so erfolgen, wie auch im Zusammenhang mit dem Übergehen von der Mitsystemspannung zur Raumzeigerspannung, oder umgekehrt, nachfolgend noch beschrieben wird. Beim Übergang von dem Raumzeigerblindstromwert zum Mitsystemblindstromwert kann sich der Mitsystemblindstromwert durch die kontinuierliche Weiterberechnung auch weiterhin noch ändern. Besonders kann sich der Mitsystemblindstromwert dabei dadurch noch ändern, dass die Mitsystemspannung sich noch ändert.

Gemäß einer Ausführungsform wird vorgeschlagen, dass der Störungsbetrieb und/oder das Vorgeben des Blindstroms in Abhängigkeit von einer Raumzeigerspannung für einen Störungszeitraum durchgeführt wird, wobei der Störungszeitraum kleiner als eine Netzperiode ist, insbesondere im Bereich von 5% bis 50% der Netzperiode liegt. Der Störungszeitraum kann auch der Übergangszeit entsprechen. Es wurde erkannt, dass spätestens nach einer Netzperiode die Mitsystemspannung wieder eine gute Referenzierungsgröße ist und dann schnell dahin zurückgewechselt werden sollte. Der Störungszeitraum, für den auf die Raumzeigerspannung referenziert wird, beinhaltet vorzugsweise keinen Überblendzeitraum.

Außerdem oder alternativ wird vorgeschlagen, dass von einem Vorgeben des Blindstroms in Abhängigkeit von einer Raumzeigerspannung in ein Vorgeben des Blindstroms in Abhängigkeit von einer Mitsystemspannung in einem Überblendzeitraum übergegangen wird, was auch als überblenden bezeichnet werden kann. Dabei wird vorgeschlagen, dass der Überblendzeitraum kleiner als eine Netzperiode ist, insbesondere im Bereich von 20% bis 90% der Netzperiode liegt. Auch hier liegt die Erkenntnis zu Grunde, dass die Mitsystemspannung über eine Netzperiode bestimmt wird und somit nach Ablauf einer Netzperiode einen guten Wert aufweist und daher innerhalb einer Netzperiode zur Referenzierung auf die Mitsystemspannung übergeblendet werden sollte.

Gemäß einer Ausführungsform wird vorgeschlagen, dass beim Wechseln in den Störungsbetrieb das Vorgeben des Blindstroms in Abhängigkeit von der Mitsystemspannung in das Vorgeben des Blindstroms in Abhängigkeit von der Raumzeigerspannung wie folgt übergeht. Der Blindstrom wird in Abhängigkeit eines Referenzwertes vorgegeben und der Referenzwert geht von der Mitsystemspannung über einen vorgebbaren Übergangsverlauf in die Raumzeigerspannung über. Dieser Übergangsverlauf kann auch als Übergangsverlauf der Mitsystemspannung bezeichnet werden.

Hier liegt die Erkenntnis zugrunde, dass ein schneller Übergang des Blindstroms von der einen Abhängigkeit in die andere Abhängigkeit zwar wichtig ist, ein sprunghafter Übergang aber kritisch sein kann und zu vermeiden ist. Dafür wird vorgeschlagen, dass der Blindstrom in Abhängigkeit von einem Referenzwert vorgegeben wird. Der Referenzwert ist insoweit ein künstlicher Wert, der insbesondere innerhalb eines Übergangszeitraums vom aktuellen Wert der Mitsystemspannung zum aktuellen Wert der Raumzeigerspannung übergeht. Die Eingangsgröße zum Vorgeben des Blindstroms ändert sich dadurch dann nicht mehr sprunghaft, sondern kann besonders kontinuierlich und über einen vorgebbaren Übergangsverlauf übergehen.

Eine bevorzugte Möglichkeit ist, dass der vorgebbare Übergangsverlauf linear ist. Demnach kann der Wert der Mitsystemspannung in einer zeitlichen Darstellung über einen vorgegeben Änderungszeitraum linear, also entlang einer Geraden, zum Wert der Raumzeigerspannung übergehen. Anschaulich wäre in dieser zeitlichen Darstellung somit der Wert der Mitsystemspannung mit dem Wert der Raumzeigerspannung über eine Gerade verbunden. Der Referenzwert bewegt sich dann in Abhängigkeit der Zeit über diesen Änderungszeitraum entlang dieser Gerade.

Sollte sich während dieses Änderungszeitraums der Wert der Mitsystemspannung und/oder der Wert der Raumzeigerspannung verändern, so kann der lineare Übergangsverlauf dem folgen. Bezogen auf das anschauliche Beispiel der Verbindung mittels einer Geraden können sich also die beiden Endpunkte der Mitsystemspannung und die Raumzeigerspannung verbindenden Geraden mitbewegen.

Außerdem oder alternativ wird vorgeschlagen, dass der vorgebbare Übergangsverlauf dadurch realisiert wird, dass sich der Referenzwert aus einer Mitsystemspannung mit einer ersten Gewichtung und einer Raumzeigerspannung mit einer zweiten Gewichtung zusammensetzt und die erste Gewichtung mit der Zeit abnimmt, während die zweite Gewichtung mit der Zeit zunimmt. Insbesondere wird vorgeschlagen, dass die erste Gewichtung mit der Zeit von 1 auf 0 abnimmt, während die zweite Gewichtung mit der Zeit von 0 auf 1 zunimmt. Insbesondere kann der Referenzwert ein Mittelwert sein zwischen der gewichteten Mitsystemspannung und der gewichteten Raumzeigerspannung.

Wenn die erste Gewichtung dabei von 1 auf 0 abnimmt, während die zweite Gewichtung zeitgleich von 0 auf 1 zunimmt, ergibt sich ein linearer Übergangsverlauf. Durch diese vorgeschlagene Verwendung einer ersten und zweiten Gewichtung kann auch auf einfache Art und Weise eine während der Übergangszeit auftretende Veränderung der Mitsystemspannung und/oder der Raumzeigerspannung berücksichtigt werden. Diese erste und zweite Gewichtung können auch als erste und zweite Gewichtung des Übergangs der Mitsystemspannung bezeichnet werden.

Gemäß einer Ausführungsform wird vorgeschlagen, dass das Vorgeben des Blindstroms in Abhängigkeit von der Raumzeigerspannung zurück in das Vorgeben des Blindstroms in Abhängigkeit von der Mitsystemspannung wie folgt übergeht. Der Blindstrom kann dabei in Abhängigkeit von einem Referenzwert vorgegeben werden, wobei der Referenzwert von der Raumzeigerspannung über einen vorgebbaren Übergangsverlauf in die Mitsystemspannung übergeht. Es wird somit vorgeschlagen, dass auch die Veränderung der Abhängigkeit des Blindstroms zurück von der Raumzeigerspannung hin zur Mitsystemspannung über einen vorgebbaren Übergangsverlauf erfolgt. Dieser Übergangsverlauf kann auch als Übergangsverlauf der Raumzeigerspannung bezeichnet werden. Varianten der Umsetzung erfolgen sinngemäß wie dies vorstehend im Zusammenhang mit der Ausführungsform erläutert wurde, die beschreiben, wie der Blindstrom in seiner Abhängigkeit von der Mitsystemspannung zur Raumzeigerspannung wechselt.

Insbesondere wird auch bei dem Zurückwechseln des Blindstroms in Abhängigkeit von der Raumzeigerspannung zurück zur Abhängigkeit von der Mitsystemspannung vorgeschlagen, dass der vorgebbare Übergangsverlauf linear ist. Außerdem oder alternativ wird vorgeschlagen, dass der vorgebbare Übergangsverlauf dadurch realisiert wird, dass sich der Referenzwert aus einer Mitsystemspannung mit einer ersten Gewichtung und einer Raumzeigerspannung mit einer zweiten Gewichtung zusammensetzt, und die erste Gewichtung mit der Zeit zunimmt, insbesondere von 0 auf 1, während die zweite Gewichtung abnimmt, insbesondere von 1 auf 0. Somit kann auch die Abhängigkeit des Blindstroms zurück vom Störungsbetrieb zum Normalbetrieb ohne Sprung durchgeführt werden. Diese erste und zweite Gewichtung können auch als erste und zweite Gewichtung des Übergangs der Raumzeigerspannung bezeichnet werden.

Statt als indirektes Verfahren den Referenzwert von der Mitsystemspannung zur Raumzeigerspannung übergehen zu lassen, bzw. umgekehrt von der Raumzeigerspannung zurück zur Mitsystemspannung, können als direktes Verfahren auch zwei Blindströme berechnet werden und der vorgegebene Blindstrom dann von dem einen Blindstrom zum anderen übergehen.

Vorzugsweise wird daher vorgeschlagen, dass beim Wechseln in den Störungsbetrieb das Vorgeben des Blindstroms in Abhängigkeit von der Mitsystemspannung in das Vorgeben des Blindstroms in Abhängigkeit von der Raumzeigerspannung gemäß einem vorgebbaren Übergangsverlauf übergeht, insbesondere so, dass ein Mitsystemblindstrom als Blindstrom in Abhängigkeit von der Mitsystemspannung berechnet wird, ein Raumzeigerblindstrom als Blindstrom in Abhängigkeit von der Raumzeigerspannung berechnet wird und ein vorgegebener Blindstrom von dem Mitsystemblindstrom gemäß einem vorgebbaren Übergangsverlauf zum Raumzeigerblindstrom übergeht, und insbesondere der vorgebbare Übergangsverlauf linear ist, und/oder der vorgebbare Änderungsverlauf dadurch realisiert wird, dass sich der vorgegebene Blindstrom aus dem Mitsystemblindstrom mit einer ersten Gewichtung und dem Raumzeigerblindstrom mit einer zweiten Gewichtung additiv zusammensetzt und die erste Gewichtung mit der Zeit abnimmt, insbesondere von 1 auf 0, während die zweite Gewichtung zunimmt, insbesondere von 0 auf 1. Dieser Übergangsverlauf kann auch als Übergangsverlauf des Mitsystemblindstroms bezeichnet werden. Diese erste und zweite Gewichtung können auch als erste und zweite Gewichtung des Übergangs des Mitsystemblindstroms bezeichnet werden.

Außerdem oder alternativ wird vorgeschlagen, dass das Vorgeben des Blindstroms in Abhängigkeit von der Raumzeigerspannung zurück in das Vorgeben des Blindstroms in Abhängigkeit von der Mitsystemspannung dadurch übergeht, dass der vorgegebene Blindstrom von dem Raumzeigerblindstrom gemäß einem vorgebbaren Übergangsverlauf zurück zum Mitsystemblindstrom übergeht, und insbesondere der vorgebbare Übergangsverlauf linear ist, und/oder der vorgebbare Übergangsverlauf dadurch realisiert wird, dass sich der vorgegebene Blindstrom aus dem Mitsystemblindstrom mit einer ersten Gewichtung und dem Raumzeigerblindstrom mit einer zweiten Gewichtung additiv zusammensetzt und die erste Gewichtung mit der Zeit zunimmt, insbesondere von 0 auf 1, während die zweite Gewichtung abnimmt, insbesondere von 1 auf 0. Dieser Übergangsverlauf kann auch als Übergangsverlauf des Raumzeigerblindstroms bezeichnet werden. Diese erste und zweite Gewichtung können auch als erste und zweite Gewichtung des Übergangs des Raumzeigerblindstroms bezeichnet werden.

Die Erläuterungen zum direkten Verfahren gelten sinngemäß auch für das indirekte Verfahren. Gewichtungen können bei diesem direkten Verfahren wie die Gewichtungen beim indirekten Verfahren verwendet und vorgegeben werden. Auch der vorgebbare Übergangsverlauf kann bei beiden Verfahren grundsätzlich gleich sein, wobei natürlich eine Anpassung an die physikalische Einheit zu berücksichtigen ist.

Gemäß einer Ausführungsform wird vorgeschlagen, dass bei Unterbrechung einer Messung der Netzspannung die Raumzeigerspannung durch einen umlaufenden Spannungszeiger geschätzt wird. Dafür wird vorgeschlagen, dass der umlaufende Spannungszeiger abhängig von einem Wert der Raumzeigerspannung vor der Unterbrechung der Messung der Netzspannung berechnend wird, und dass er abhängig von einer Nennfrequenz der Netzspannung und/oder abhängig von einer zuletzt erfassten Frequenz der Netzspannung weiter berechnet wird. Besonders wird vorgeschlagen, dass der Spannungszeiger den Wert der Raumzeigerspannung nach Betrag und Phase vor der Unterbrechung der Messung der Netzspannung annimmt und mit einer Kreisfrequenz entsprechend der Nennfrequenz bzw. entsprechend der zuletzt erfassten Frequenz der Netzspannung kontinuierlich umläuft. Der Spannungszeiger läuft also mit der Kreisfrequenz $\omega$ um und diese Kreisfrequenz berechnet sich als $\omega = 2 * \pi * f_N$ oder als $\omega = 2\pi * f$, wobei $f_N$ für die Nennfrequenz der Netzspannung steht und $f$ für die zuletzt erfasste Frequenz der Netzspannung steht, die auch als Netzfrequenz bezeichnet werden kann.

Hier liegt besonders die Erkenntnis zugrunde, dass durch die Verwendung dieses Spannungszeigers auch im Falle der Unterbrechung einer Messung der Netzspannung zumindest kurzfristig eine Spannungsreferenz nach Betrag und Phase gegeben werden kann, die das Fortsetzen einer Einspeisung, insbesondere das Fortsetzen einer Blindleistungseinspeisung ermöglicht. Das Unterbrechen der Messung der Netzspannung kann auch dadurch begründet sein, dass die Netzspannung tatsächlich kurzfristig und für einen kurzen Zeitraum, der insbesondere unter einer Sekunde liegt, zusammenbricht, oder zumindest einbricht. In diesem Fall kann es hilfreich sein, trotzdem Blindleistung in das elektrische Versorgungsnetz einzuspeisen, um eine Netzstützung zu gewährleisten.

Es wird vorgeschlagen, den einzuspeisenden Strom, und damit auch den einzuspeisenden Blindstrom, nach der Methode des Toleranzbandverfahrens vorzugeben und einzuspeisen. Beim Toleranzbandverfahren wird der erzeugte Strom gemessen, diese Messung bzw. der Messwert zurückgeführt und davon abhängig der Strom erzeugt. Damit kann auch bei schwankender oder sogar einbrechender Netzspannung ein gewünschter Strom eingestellt und erzeugt werden. Besonders bevorzugt wird das somit für den Fall einer Unterbrechung einer Messung der Netzspannung vorgeschlagen, wenn die Raumzeigerspannung durch einen umlaufenden Spannungszeiger geschätzt wird. Das Toleranzbandverfahren kann aber auch dauerhaft zum Steuern des einzuspeisenden Stroms verwendet werden, also auch im Normalbetrieb.

Besonders wird vorgeschlagen, dass abhängig einer Spannungsveränderung der Netzspannung von einem Normalbetrieb in einen Störungsbetrieb gewechselt wird. Dabei wird zum Einspeisen des Blindstroms in Abhängigkeit von der Mitsystemspannung auf eine Einspeisung des Blindstroms in Abhängigkeit von einer Raumzeigerspannung gewechselt. Für die Einspeisung des Blindstroms wird also von einer Referenzierung auf die Mitsystemspannung auf eine Referenzierung auf die Raumzeigerspannung gewechselt. Dieses Wechseln kann auch als erster Schritt angesehen werden, mit dem der Blindstrom schnell auf Spannungsänderungen reagieren kann, um dadurch eine Spannungsstabilisierung im elektrischen Versorgungsnetz zu erreichen.

Wenn nun zusätzlich noch die Netzspannung einbricht und/oder eine Messung der Netzspannung unterbrochen wird, kann zusätzlich die Raumzeigerspannung abhängig eines umlaufenden Spannungszeigers geschätzt werden. Die Blindleistungseinspeisung referenziert dann auf diesen umlaufenden Spannungszeiger. Diese Umschaltung der Referenzierung auf den umlaufenden Spannungszeiger kann somit als zweiter Schritt angesehen werden. Dadurch, insbesondere durch den ersten und zweiten Schritt zusammen, ist auf vorteilhafte Art und Weise ein schnelles Durchsteuern durch einen Netzspannungsfehler möglich.

Erfindungsgemäß wird auch eine Windenergieanlage zum Einspeisen elektrischer Leistung in das elektrische, dreiphasige Versorgungsnetz vorgeschlagen. Die Windenergieanlage weist dazu eine Wechselrichtereinrichtung auf. Außerdem weist die Windenergieanlage eine Steuervorrichtung auf, und die Windenergieanlage ist dazu vorbereitet, das Einspeisen mittels eines Verfahrens gemäß wenigstens einer vorstehend beschriebenen Ausführungsform durchzuführen. Insbesondere können die entsprechenden Verfahrensschritte dazu in der Steuereinrichtung implementiert sein. Somit ist dann die Steuervorrichtung dazu vorbereitet, das Einspeisen gemäß wenigstens einem vorstehend erläuterten Verfahren durchzuführen.

Besonders sind Messsensoren in der Windenergieanlage oder im Zugriff der Windenergieanlage vorgesehen, die eine Netzspannung dreiphasig erfassen. Daraus können sowohl eine Mitsystemspannung als auch eine Gegensystemspannung und auch eine Raumzeigerspannung ermittelt werden. Besonders die Mitsystemspannung oder die Raumzeigerspannung kann als Eingangsgröße für das Einspeisen der Blindleistung verwendet werden. Das Bestimmen der Mitsystemspannung, der Gegensystemspannung und der Raumzeigerspannung kann mittels der Steuervorrichtung durchgeführt werden. Die Steuervorrichtung kann zudem diese Spannungswerte auswerten und dabei zwischen der Mitsystemspannung und der Raumzeigerspannung als Eingangsgröße zum Start der Blindleistung wechseln. Außerdem kann die Steuervorrichtung einen Übergang zum Wechseln zwischen der Mitsystemspannung und der Raumzeigerspannung oder umgekehrt steuern.

Die Erfindung wird nun nachfolgend beispielhaft anhand von Ausführungsformen unter Bezugnahme auf die begleitenden Figuren näher erläutert.

Fig. 1      zeigt eine Windenergieanlage in einer perspektivischen Darstellung.

Fig. 2      zeigt schematisch eine Regelungsstruktur.

Fig. 3      zeigt ein Element der Regelungsstruktur der Fig. 2

Fig. 4 und 5      zeigen jeweils Diagramme von Spannungsverläufen und je einen daraus auf unterschiedliche Art und Weise berechneten Blindstromverlauf.

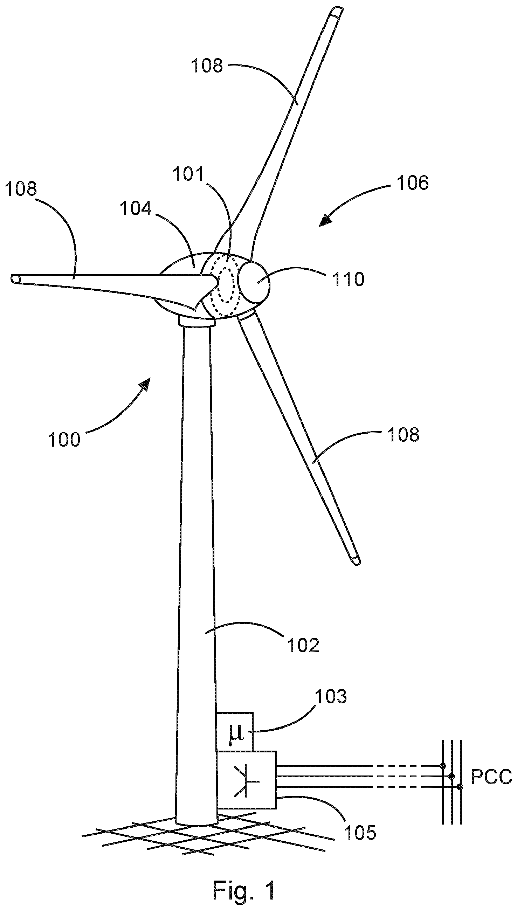

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

Die Windenergieanlage 100 weist dabei einen elektrischen Generator 101 auf, der in der Gondel 104 angedeutet ist. Mittels des Generators 101 kann elektrische Leistung erzeugt werden. Zum Einspeisen elektrischer Leistung ist eine Einspeiseeinheit 105 vorgesehen, die besonders als Wechselrichter ausgebildet sein kann. Damit kann ein dreiphasiger Einspeisestrom und/oder eine dreiphasige Einspeisespannung nach Amplitude, Frequenz und Phase erzeugt werden, zum Einspeisen an einem Netzanschlusspunkt PCC. Das kann direkt oder auch gemeinsam mit weiteren Windenergieanlagen in einem Windpark erfolgen. Zum Steuern der Windenergieanlage 100 und auch der Einspeiseeinheit 105 ist eine Anlagensteuerung 103 vorgesehen. Die Anlagensteuerung 103 kann auch Vorgabewerte von extern, insbesondere von einem zentralen Parkrechner erhalten.

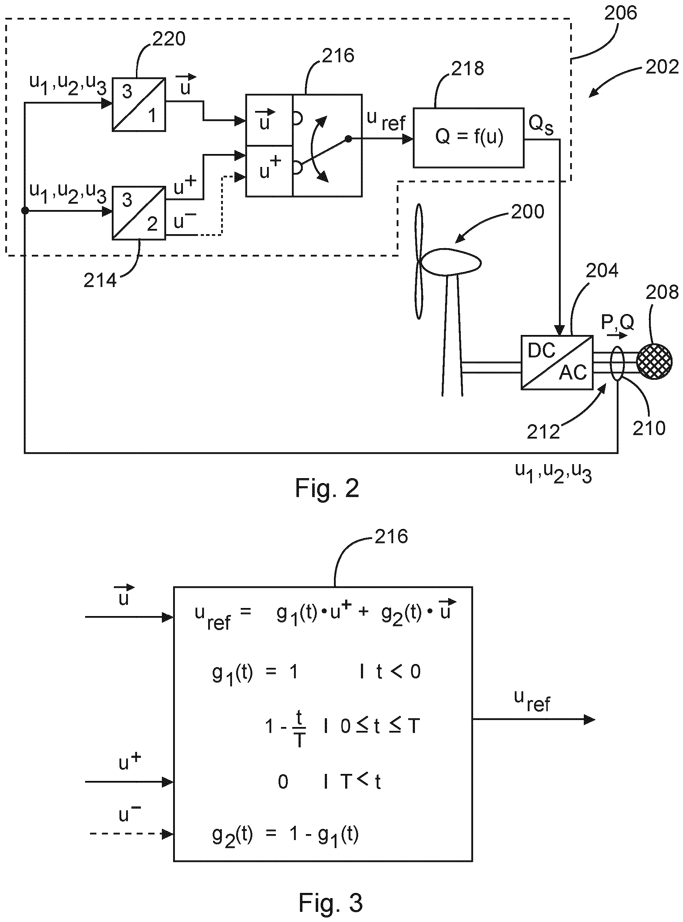

Figur 2 zeigt schematisch eine Regelungsstruktur 202, die einen Wechselrichter 204 einer Windenergieanlage 200 steuert. Die Windenergieanlage 200 kann der Windenergieanlage 100 der Figur 1 entsprechen. Die Windenergieanlage 200 ist besonders schematisch zu verstehen und sie kann die Reglerstruktur 202 bzw. ihre Elemente enthalten. Die Reglerstruktur 202 kann in einer Steuervorrichtung 206 enthalten bzw. implementiert sein. Der Wechselrichter 204 kann Wirkleistung P und Blindleistung Q in ein elektrisches Versorgungsnetz 208 einspeisen.

Das vorgeschlagene Verfahren funktioniert gemäß einer Ausführungsform so, dass die drei Spannungsphasen $u_1$, $u_2$ und $u_3$ des elektrischen Versorgungsnetzes 208 gemessen werden. Das kann mittels des Messaufnehmers 210 in dem elektrischen Versorgungsnetz 208 erfolgen, oder, wie es in der Figur 2 dargestellt ist, an einer Verbindungsleitung 212 zwischen dem Wechselrichter 204 und dem elektrischen Versorgungsnetz 208.

In einem Normalbetrieb werden diese 3 Phasenspannungen in einem Zerlegungsblock 214 nach der Methode der symmetrischen Komponenten in eine Mitsystemspannung $u^+$ und eine Gegensystemspannung $u^-$ zerlegt bzw. transformiert. Diese Mitsystemspannung $u^+$ wird in den Wechselblock 216 eingegeben. Optional kann auch die Gegensystemspannung $u^-$ in diesen Wechselblock 216 eingegeben werden, was durch einen entsprechend gestrichelten Pfeil angedeutet ist.

In dem Wechselblock 216 kann diese Mitsystemspannung $u^+$ als zur Blindleistungsbestimmung zu verwendende Spannung ausgewählt werden. Das ist in dem Wechselblock 216 durch eine entsprechende Schalterstellung angedeutet. Der Wechselblock 216 gibt dann die für die Blindleistungssteuerung zu verwendende Spannung als Referenzwert oder Referenzspannung $u_{ref}$ aus.

Die in Figur 2 angedeutete Schalterstellung des Wechselblocks 216 betrifft somit einen Normalbetrieb, in dem die Blindleistungssteuerung von der Mitsystemspannung $u^+$ abhängt. Die Referenzspannung $u_{ref}$ entspricht dann also der Mitsystemspannung $u^+$.

Zur weiteren Umsetzung wird diese Referenzspannung $u_{ref}$ als Eingangsgröße in den Blindleistungsblock 218 gegeben. In dem Blindleistungsblock 218 wird eine gewünschte Blindleistung als Funktion in Abhängigkeit von der Eingangsgröße des Blindleistungsblocks 218, also in Abhängigkeit von der Referenzspannung $u_{ref}$, berechnet und als Sollblindleistung $Q_s$ ausgegeben. Diese Sollblindleistung $Q_s$ bildet dann einen Eingangswert für den Wechselrichter 204. Insoweit bildet dieser Blindleistungssollwert $Q_s$ eine Führungsgröße zum Steuern des Wechselrichters.

Zum Steuern des Wechselrichters 204 werden noch weitere Größen benötigt, die hier der Einfachheit halber aber nicht dargestellt sind. Der Wechselrichter 204 kann durch eine eingangsseitige Gleichspannung mit Energie versorgt werden. Eine solche Gleichspannung kann er beispielsweise aus einem Generator der Windenergieanlage 200 erhalten, der einen Wechselstrom erzeugt, der gleichgerichtet wird.

Für den Fall, dass der Normalbetrieb verlassen werden muss oder soll und ein Störungsbetrieb verwendet werden soll, werden die drei Phasenspannungen $u_1$, $u_2, u_3$ in dem Transformationsblock 220 in eine Raumzeigerspannung $\vec{u}$ transformiert. Diese Raumzeigerspannung $\vec{u}$ wird ebenfalls in den Wechselblock 216 eingegeben. Durch den angedeuteten Schalter kann der Wechselblock 216 bei Bedarf, insbesondere also im Störungsbetrieb auf diese Raumzeigerspannung $\vec{u}$ als Eingangsgröße für die Blindleistungssteuerung wechseln. Insoweit dient der in dem Wechselblock 216 angedeutete Schalter aber nur der Veranschaulichung. Tatsächlich wird vorgeschlagen, nicht zwischen der Mitsystemspannung $u^+$ und der Raumzeigerspannung $\vec{u}$ hart umzuschalten, sondern mit einer Übergangsfunktion zu wechseln. Das wird weiter unten noch exemplarisch näher erläutert und etwaige vorstehende oder nachfolgende Erläuterungen zum Wechseln können in diesen Wechselblock 216 implementiert sein.

Eine mögliche Realisierung des Wechselblocks 216 ist in Figur 3 dargestellt. Dort ist ein linearer Wechsel der Referenzspannung $u_{ref}$ von der Mitsystemspannung $u^+$ zur Raumzeigerspannung $\vec{u}$ durch die Gewichtungsfunktionen $g_1(t)$ und $g_2(t)$ als mathematische Funktion implementiert. Die erste Gewichtungsfunktion $g_1(t)$ fällt somit linear von 1 auf 0 über den Übergangszeitraum T ab, sodass der Anteil der Mitsystemspannung $u^+$ über diesen Übergangszeitraum vom Maximalwert auf 0 abfällt. Gleichzeitig steigt die Gewichtungsfunktion $g_2(t)$ über den Übergangszeitraum T von 0 auf 1 an, sodass der Anteil der Raumzeigerspannung über den Übergangszeitraum von 0 auf den Maximalwert ansteigt.

Entsprechend kann auch, wenn die Referenzspannung $u_{ref}$ von der Raumzeigerspannung $\vec{u}$ zur Mitsystemspannung $u^+$ zurückwechseln soll, der gleiche mathematische Zusammenhang implementiert werden, wobei die Gewichtungsfunktionen $g_1(t)$ und $g_2(t)$ zu tauschen wären. Es kann aber auch für das Zurückwechseln ein kürzerer oder längerer Übergangszeitraum verwendet werden, um ein Beispiel einer Variation zu erwähnen.

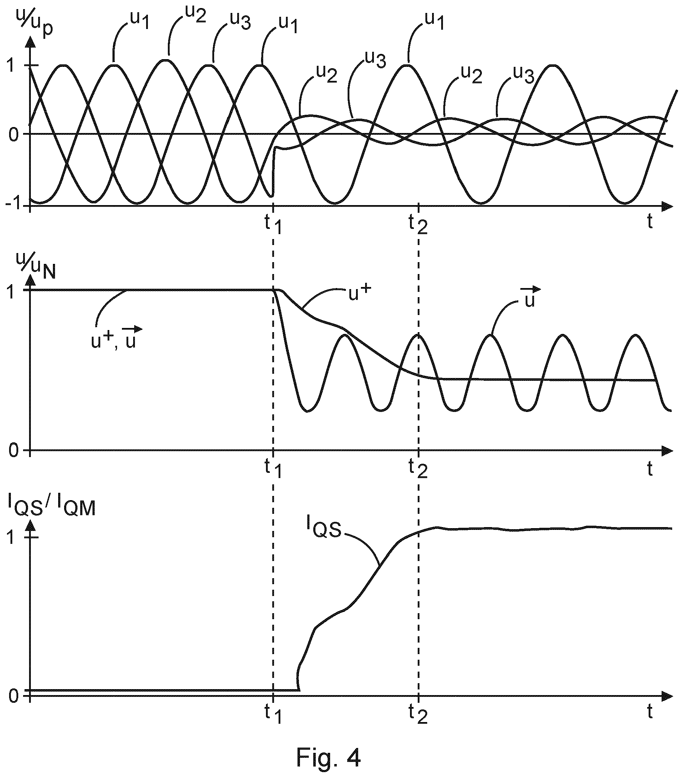

Figur 4 zeigt eine Einspeisung des Blindstroms im Mit- und Gegensystem. Da die Bestimmung der Mit- und Gegensystemspannungen nicht sofort möglich ist, sondern über die Dauer einer Periode der Netzspannung erfolgt, kann auch der Anstieg der daraus abgeleiteten Blindstromeinspeisung nur "langsam" erfolgen. Das ist in Figur 4 illustriert.

Figur 4 enthält drei einzelne Diagramme, von denen das obere den Verlauf der drei gemessenen Phasenspannungen $u_1$, $u_2$ und $u_3$ zeigt, nämlich den Verlauf der Augenblickswerte. Zum Zeitpunkt $t_1$ brechen die beiden Phasenspannungen $u_2$ und $u_3$ auf einen kleinen Wert ein.

Das mittlere Diagramm zeigt die Mitsystemspannung $u^+$ und die Raumzeigerspannung $\vec{u}$, die aus den drei Phasenspannungen $u_1$, $u_2$ und $u_3$ berechnet

wurden und in dem Diagramm auf Nennspannung $U_N$ normiert dargestellt sind. Es ist zu erkennen, dass vor dem Spannungseinbruch zum Zeitpunkt $t_1$ die Mitsystemspannung $u^+$ und die Raumzeigerspannung $\vec{u}$ etwa gleich sind, in dem Diagramm jedenfalls nicht zu unterscheiden sind. Die drei Phasenspannungen $u_1$, $u_2$ und $u_3$ sind somit noch etwa symmetrisch zueinander. Nach dem Spannungseinbruch verändert sich die Raumzeigerspannung $\vec{u}$ schneller und damit ist aus ihr der Spannungseinbruch schneller zu erkennen. Prinzipbedingt behält die Raumzeigerspannung $\vec{u}$ allerdings eine Schwingung.

Die Mitsystemspannung $u^+$ reagiert langsamer auf den Spannungseinbruch und erreicht nach einer Periode T, nämlich zum Zeitpunkt $t_2$, einen neuen Wert.

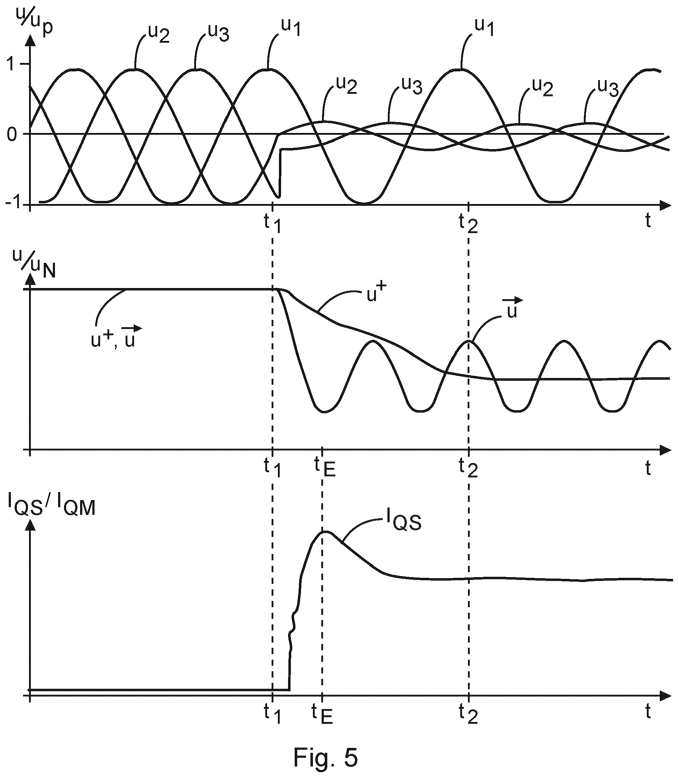

Das untere Diagramm der Figur 4 zeigt einen aus der Mitsystemspannung $u^+$ bestimmten Blindstrom zu Einspeisung einer Blindleistung, der als Sollblindstrom $I_{QS}$ bezeichnet ist. Der Sollblindstrom $I_{QS}$ erreicht somit auch erst nach einer Periode T, also zum Zeitpunkt $t_2$, einen neuen Wert. Das untere Diagramm der Figur 4, gleiches gilt für die Figur 5, geht zur Veranschaulichung davon aus, dass der Sollblindstrom einen maximalen Blindstrom $I_{QM}$ erreicht, auf den das Diagramm normiert ist.

Um den Blindstrom schneller bereitstellen zu können wird eine Variante vorgeschlagen, die in Figur 5 veranschaulicht ist. Figur 5 zeigt drei Diagramme und das obere und mittlere Diagramm entsprechen dem oberen und mittleren Diagramm der Figur 4, bis auf Abweichungen in der zeitlichen Auflösung, die hier nicht von Bedeutung sind. Somit wird zur Erläuterung des oberen und mittleren Diagramms der Figur 5 auf die Ausführungen zur Figur 4 verwiesen.

Die Berechnung des Blindstroms unterscheidet sich allerdings zwischen den Figuren 4 und 5. Das untere Diagramm zeigt somit einen berechneten Sollblindstrom $I_{QS}$, wie in dem unteren Diagramm der Figur 4, wobei der Sollblindstrom $I_{QS}$ aber anders berechnet wird.

Es wird vorgeschlagen, dass die initiale Blindstrombereitstellung, nämlich initial ab einem erkannten Störungskriterium, anhand der gemessenen Raumzeigerspannung $\vec{u}$ durchgeführt wird. Das Störungskriterium ist in dem in Figur 5 gezeigten Beispiel der Spannungseinbruch der beiden Phasenspannungen $u_2$ und $u_3$ auf einen kleinen Wert. Diese initiale Blindstrombereitstellung erfolgt somit ab dem Zeitpunkt $t_1$.

Ab dem Zeitpunkt $t_1$ erfolgt somit die initiale Blindstrombereitstellung, also die Bestimmung des Sollblindstromes, anhand der gemessenen Raumzeigerspannung $\vec{u}$. Sobald das erste Minimum in der Raumzeigerspannung erkannt wird, wird der so gewonnene Sollwert eingefroren. Das ist etwas zu Zeitpunkt $t_E$ der Fall. Anschließend kann über einen Zeitraum von 15 ms vom raumzeigerbasierten Sollwert auf den mitsystembasierten Sollwert übergeblendet werden. Der Zeitraum von 15ms ist etwas kleiner als eine Periode T, die hier 20ms beträgt, da ein 50Hz-Netz zu Grunde liegt.

Es wurde erkannt, dass es sinnvoll sein kann, eine schnellere Einspeisung von Blindstrom im Fehlerfall, der auch als Störungsfall bezeichnet werden kann, durchzuführen, nämlich möglichst innerhalb der ersten 10ms.

Durch die erfindungsgemäße Lösung ist eine schnellere Blindstrombereitstellung zur Netzstützung erreichbar, als dies bei Einspeisung von Blindleistung ausschließlich basierend auf der Mitsystemspannung bisher bekannt ist. Dadurch kann auch eine höhere Netzstabilität erreicht werden.

Es wird somit vorgeschlagen, einen Fehler mit einer Raumzeigerspannung zu erkennen, und dann entsprechend auf Raumzeigerspannung zur Referenzierung umzuschalten. Das ist schneller als die Referenzierung auf das Mitsystem. Wenn das System eingependelt ist, kann zurück auf die Referenzierung auf das Mitsystem umgeschaltet werden.

Ein erkanntes Problem ist, einen guten Übergang von Referenzierung auf Mitsystem, zu Referenzierung auf Raumzeigerspannung und zurück zu finden. Dazu wird ein Überblenden vorgeschlagen.

Das Überblenden von Referenzierung auf Raumzeigerspannung auf das Referenzieren auf das Mitsystem, also die Mitsystemspannung, kann beim Minimum der Raumzeigerspannung beginnen. Es kommen auch andere Möglichkeiten in Betracht, wie bspw. nur für eine vorgegebene Zeit auf die Raumzeigerspannung zu referenzieren. Eine solche vorgegebene Zeit, kann bspw. ein Viertel einer Netzperiode betragen. Es kommt auch in Betracht, die Raumzeigerspannung auszuwerten und auf die Raumzeigerspannung zu referenzieren, bis sie eine Wendestelle aufweist, und dann zur Referenzierung auf die Mittsystemspannung zu wechseln.

**Patentansprüche**

1. Verfahren zum Einspeisen elektrischer Leistung in ein elektrisches, dreiphasiges Versorgungsnetz mittels einer Wechselrichtereinrichtung (105, 204), wobei

   das elektrische Versorgungsnetz (208) eine dreiphasige Netzspannung mit einer ersten, zweiten und dritten Netzspannungsphase aufweist,
   umfassend die Schritte:

   - Einspeisen der elektrischen Leistung in einem Normalbetrieb, wenn für das elektrische Versorgungsnetz (208) ein störungsfreier Betrieb erkannt wurde, wobei im Normalbetrieb

      - von der Netzspannung eine Mitsystemspannung ($u^+$) und optional eine Gegensystemspannung ($u^-$) erfasst wird und
      - ein Blindstrom wenigstens in Abhängigkeit von der Mitsystemspannung ($u^+$) und optional in Abhängigkeit von der Gegensystemspannung ($u^-$) vorgegeben wird, und

- Wechseln in einen Störungsbetrieb, wenn eine Spannungsveränderung der Netzspannung ein vorbestimmtes Störungskriterium erfüllt, insbesondere wenn die Spannungsveränderung einen vorgebbaren Mindeständerungsbetrag oder Mindeständerungsgradientenbetrag überschreitet, wobei im Störungsbetrieb, zumindest unmittelbar nach dem Wechsel,

- der Blindstrom in Abhängigkeit von einer Raumzeigerspannung ($\vec{u}$) vorgegeben wird.

2. Verfahren nach Anspruch 1, **dadurch gekennzeichnet, dass** die Raumzeigerspannung $\vec{u}$, definiert ist durch die Gleichung

$$\vec{u} = \left[ u_1 + u_2 \exp\left( j\frac{2}{3}\pi \right) + u_3 \exp\left( j\frac{4}{3}\pi \right) \right],$$

mit $u1$, $u2$ und $u3$ jeweils als Augenblickswert, insbesondere als momentaner Messwert der ersten, zweiten bzw. dritten Netzspannungsphase.

3. Verfahren nach Anspruch 1 oder 2, **dadurch gekennzeichnet, dass** die Raumzeigerspannung ($\vec{u}$) auch im Normalbetrieb ständig bestimmt wird und abhängig von der erfassten Raumzeigerspannung ($\vec{u}$) auf den Störungsbetrieb umgeschaltet wird.

4. Verfahren nach einem der vorstehenden Ansprüche, **dadurch gekennzeichnet, dass**

- das Vorgeben des Blindstroms in Abhängigkeit von der Raumzeigerspannung ($\vec{u}$) zurück in
- das Vorgeben des Blindstroms in Abhängigkeit von der Mitsystemspannung ($u^+$) übergeht,
- wenn die Mitsystemspannung ($u^+$) im Wesentlichen einen stationären Wert angenommen hat und/oder wenn Änderungen der Mitsystemspannung ($u^+$) dem Betrage nach unterhalb eines vorgebbaren Grenzgradienten liegen und/oder
- wenn die Raumzeigerspannung ($\vec{u}$) im Falle eines Spannungseinbruchs einer oder mehrerer Netzspannungsphasen einen Minimalwert erreicht hat, und/oder
- wenn ein Verlauf der Raumzeigerspannung ($\vec{u}$) eine Wendestelle erreicht hat und/oder
- wenn eine vorbestimmte Übergangszeit nach Erkennen des Störungsbetriebs verstrichen ist.

5. Verfahren nach einem der vorstehenden Ansprüche, **dadurch gekennzeichnet, dass**

- ab dem Wechseln in den Störungsbetrieb das Vorgeben des Blindstroms in Abhängigkeit von der Raumzeigerspannung ($\vec{u}$) erfolgt, bis ein Rückschaltkriterium erkannt wurde,
- bei Erkennen des Rückschaltkriteriums der Blindstromwert, der in Abhängigkeit von der Raumzeigerspannung ($\vec{u}$) berechnet wurde, als Raumzeigerblindstromwert gehalten wird,
- ab Erkennen des Rückschaltkriterium kontinuierlich ein Mitsystemblindstromwert in Abhängigkeit von der Mitsystemspannung ($u^+$) berechnet wird, und
- der vorgegebene Blindstrom dadurch berechnet wird, dass der gehaltene Raumzeigerblindstromwert in den Mitsystemblindstromwert über einen vorgebbaren Übergangsverlauf übergeht.

6. Verfahren nach einem der vorstehenden Ansprüche, **dadurch gekennzeichnet, dass**

- der Störungsbetrieb und/oder das Vorgeben des Blindstroms in Abhängigkeit von einer Raumzeigerspannung ($\vec{u}$) für einen Störungszeitraum durchgeführt wird, wobei der Störungszeitraum kleiner als eine Netzperiode ist, insbesondere im Bereich von 5% bis 50% der Netzperiode liegt, und/oder
- von einem Vorgeben des Blindstroms in Abhängigkeit von einer Raumzeigerspannung ($\vec{u}$) in ein Vorgeben des Blindstroms in Abhängigkeit von einer Mitsystemspannung ($u^+$) in einem Überblendzeitraum übergegangen wird, wobei der Überblendzeitraum kleiner als eine Netzperiode ist, insbesondere im Bereich von 20% bis 90% der Netzperiode liegt.

7. Verfahren nach einem der vorstehenden Ansprüche, **dadurch gekennzeichnet, dass** beim Wechseln in den Störungsbetrieb

- das Vorgeben des Blindstroms in Abhängigkeit von der Mitsystemspannung ($u^+$) in
- das Vorgeben des Blindstroms in Abhängigkeit von der Raumzeigerspannung ($\vec{u}$) dadurch übergeht, dass
- der Blindstrom in Abhängigkeit von einem Referenzwert vorgegeben wird und der Referenzwert von der Mitsystemspannung ($u^+$) über einen vorgebbaren Übergangsverlauf in die Raumzeigerspannung ($\vec{u}$) übergeht, wobei insbesondere

- der vorgebbare Übergangsverlauf linear ist, und/oder

- der vorgebbare Übergangsverlauf dadurch realisiert wird, dass sich der Referenzwert aus einer Mitsystemspannung ($u^+$) mit einer ersten Gewichtung und einer Raumzeigerspannung ($\vec{u}$) mit einer zweiten Gewichtung zusammensetzt und die erste Gewichtung mit der Zeit abnimmt, insbesondere von 1 auf 0, während die zweite Gewichtung zunimmt, insbesondere von 0 auf 1, und/oder dass

- das Vorgeben des Blindstroms in Abhängigkeit von der Raumzeigerspannung ($\vec{u}$) zurück in
- das Vorgeben des Blindstroms in Abhängigkeit von der Mitsystemspannung ($u^+$) dadurch übergeht, dass
- der Blindstrom in Abhängigkeit von einem Referenzwert vorgegeben wird und der Referenzwert von der Raumzeigerspannung ($\vec{u}$) über einen vorgebbaren Übergangsverlauf in die Mitsystemspannung ($u^+$) übergeht, wobei

  - der vorgebbare Übergangsverlauf insbesondere linear ist, und/oder
  - der vorgebbare Übergangsverlauf dadurch realisiert wird, dass sich der Referenzwert aus einer Mitsystemspannung ($u^+$) mit einer ersten Gewichtung und einer Raumzeigerspannung ($\vec{u}$) mit einer zweiten Gewichtung zusammensetzt und die erste Gewichtung mit der Zeit zunimmt, insbesondere von 0 auf 1, während die zweite Gewichtung abnimmt, insbesondere von 1 auf 0.

8. Verfahren nach einem der vorstehenden Ansprüche, **dadurch gekennzeichnet, dass**
beim Wechseln in den Störungsbetrieb

  - das Vorgeben des Blindstroms in Abhängigkeit von der Mitsystemspannung ($u^+$) in
  - das Vorgeben des Blindstroms in Abhängigkeit von der Raumzeigerspannung ($\vec{u}$) gemäß einem vorgebbaren Übergangsverlauf übergeht, insbesondere so, dass
  - ein Mitsystemblindstrom als Blindstrom in Abhängigkeit von der Mitsystemspannung ($u^+$) berechnet wird,
  - ein Raumzeigerblindstrom als Blindstrom in Abhängigkeit von der Raumzeigerspannung ($\vec{u}$) berechnet wird und
  - ein vorgegebener Blindstrom von dem Mitsystemblindstrom gemäß einem vorgebbaren Übergangsverlauf zum Raumzeigerblindstrom übergeht, und insbesondere
  - der vorgebbare Übergangsverlauf linear ist, und/oder

- der vorgebbare Übergangsverlauf dadurch realisiert wird, dass sich der vorgegebene Blindstrom aus dem Mitsystemblindstrom mit einer ersten Gewichtung und dem Raumzeigerblindstrom mit einer zweiten Gewichtung additiv zusammensetzt und die erste Gewichtung mit der Zeit abnimmt, insbesondere von 1 auf 0, während die zweite Gewichtung zunimmt, insbesondere von 0 auf 1, und/oder dass
- das Vorgeben des Blindstroms in Abhängigkeit von der Raumzeigerspannung ($\vec{u}$) zurück in
- das Vorgeben des Blindstroms in Abhängigkeit von der Mitsystemspannung ($u^+$) dadurch übergeht, dass
- der vorgegebene Blindstrom von dem Raumzeigerblindstrom gemäß einem vorgebbaren Übergangsverlauf zurück zum Mitsystemblindstrom übergeht, und insbesondere
- der vorgebbare Übergangsverlauf linear ist, und/oder
- der vorgebbare Übergangsverlauf dadurch realisiert wird, dass sich der vorgegebene Blindstrom aus dem Mitsystemblindstrom mit einer ersten Gewichtung und dem Raumzeigerblindstrom mit einer zweiten Gewichtung additiv zusammensetzt und die erste Gewichtung mit der Zeit zunimmt, insbesondere von 0 auf 1, während die zweite Gewichtung abnimmt, insbesondere von 1 auf 0.

9. Verfahren nach einem der vorstehenden Ansprüche, **dadurch gekennzeichnet, dass**

  - bei Unterbrechung einer Messung der Netzspannung
  - die Raumzeigerspannung ($\vec{u}$) durch einen umlaufenden Spannungszeiger geschätzt wird und
  - der umlaufende Spannungszeiger

    - abhängig von einem Wert der Raumzeigerspannung ($\vec{u}$) vor der Unterbrechung der Messung der Netzspannung, und abhängig von
    - einer Nennfrequenz der Netzspannung und/oder abhängig von einer zuletzt erfassten Frequenz der Netzspannung, weiterberechnet wird.

10. Windenergieanlage (100, 200) zum Einspeisen elektrischer Leistung in ein elektrisches, dreiphasiges Versorgungsnetz mittels einer Wechselrichtereinrichtung, wobei
das elektrische Versorgungsnetz (208) eine dreiphasige Netzspannung mit einer ersten, zweiten und dritten Netzspannungsphase aufweist, und
die Windenergieanlage weist eine Steuervorrichtung (206) auf, und die Windenergieanlage, insbesondere die Steuervorrichtung (206), ist dazu vorbereitet, das Einspeisen gemäß den folgenden Schritten zu steuern:

- Einspeisen der elektrischen Leistung in einem Normalbetrieb, wenn für das elektrische Versorgungsnetz (208) ein störungsfreier Betrieb erkannt wurde, wobei im Normalbetrieb

- von der Netzspannung eine Mitsystemspannung ($u^+$) und optional eine Gegensystemspannung ($u^-$) erfasst wird und
- ein Blindstrom wenigstens in Abhängigkeit von der Mitsystemspannung ($u^+$) und optional in Abhängigkeit von der Gegensystemspannung ($u^-$) vorgegeben wird, und

- Wechseln in einen Störungsbetrieb, wenn eine Spannungsveränderung der Netzspannung ein vorbestimmtes Störungskriterium erfüllt, insbesondere wenn die Spannungsveränderung einen vorgebbaren Mindeständerungsbetrag oder Mindeständerungsgradientenbetrag überschreitet, wobei im Störungsbetrieb, zumindest unmittelbar nach dem Wechsel,

- der Blindstrom in Abhängigkeit von einer Raumzeigerspannung ($\vec{u}$) vorgegeben wird.

11. Windenergieanlage (100, 200) nach Anspruch 10, dazu vorbereitet, ein Verfahren gemäß einem der Ansprüche 1 bis 9 durchzuführen.

Fig. 1

Fig. 2

Fig. 3

Fig. 4

Fig. 5

Europäisches
Patentamt

European
Patent Office

Office européen
des brevets

# EUROPÄISCHER RECHERCHENBERICHT

Nummer der Anmeldung

EP 20 20 1076

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br><br>Y | DE 10 2013 210812 A1 (WOBBEN PROPERTIES GMBH [DE]) 11. Dezember 2014 (2014-12-11)<br>* Absätze [0005] - [0012], [0027], [0040] - [0058]; Ansprüche 1,6; Abbildungen 1,2 *<br>----- | 1,2,4-6, 10,11<br>3,9 | INV.<br>H02J3/18<br>F03D9/25<br>H02J3/38 |
| Y,D | DE 197 34 722 A1 (SIEMENS AG [DE]) 25. Februar 1999 (1999-02-25)<br>* Spalten 1-4; Abbildungen 1-3 *<br>----- | 3 | |
| A | DE 10 2007 049251 A1 (REPOWER SYSTEMS AG [DE]) 23. April 2009 (2009-04-23)<br>* Absätze [0005] - [0020]; Abbildungen 1-5 *<br>----- | 1-11 | |
| A | DE 10 2011 121362 A1 (RWE DEUTSCHLAND AG [DE]) 20. Juni 2013 (2013-06-20)<br>* Absätze [0007] - [0025]; Abbildungen 1-7 *<br>----- | 1-11 | |
| Y<br><br><br><br>A | WO 2008/049541 A1 (REPOWER SYSTEMS AG [DE]; FORTMANN JENS [DE]; LETAS HEINZ-HERMANN [DE]) 2. Mai 2008 (2008-05-02)<br>* Seiten 2,3; Abbildungen 1-6 *<br>----- | 9<br><br><br><br>1-8,10, 11 | RECHERCHIERTE SACHGEBIETE (IPC)<br><br>H02J<br>F03D |

Der vorliegende Recherchenbericht wurde für alle Patentansprüche erstellt

| Recherchenort | Abschlußdatum der Recherche | Prüfer |
|---|---|---|
| München | 11. März 2021 | Krasser, Bernhard |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**　　　　EP 20 20 1076

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-03-2021

| Im Recherchenbericht angeführtes Patentdokument | Datum der Veröffentlichung | Mitglied(er) der Patentfamilie | Datum der Veröffentlichung |
|---|---|---|---|
| DE 102013210812 A1 | 11-12-2014 | AR 096549 A1 | 13-01-2016 |
| | | AU 2014280257 A1 | 21-01-2016 |
| | | BR 112015030726 A2 | 25-07-2017 |
| | | CA 2914101 A1 | 18-12-2014 |
| | | CL 2015003577 A1 | 15-07-2016 |
| | | CN 105308313 A | 03-02-2016 |
| | | DE 102013210812 A1 | 11-12-2014 |
| | | DK 3008334 T3 | 03-12-2018 |
| | | EP 3008334 A1 | 20-04-2016 |
| | | ES 2701811 T3 | 26-02-2019 |
| | | JP 6195983 B2 | 13-09-2017 |
| | | JP 2016526867 A | 05-09-2016 |
| | | KR 20160019500 A | 19-02-2016 |
| | | NZ 715524 A | 25-11-2016 |
| | | PT 3008334 T | 09-01-2019 |
| | | RU 2015156049 A | 17-07-2017 |
| | | TW 201513528 A | 01-04-2015 |
| | | US 2016134121 A1 | 12-05-2016 |
| | | WO 2014198725 A1 | 18-12-2014 |
| | | ZA 201508780 B | 25-01-2017 |
| DE 19734722 A1 | 25-02-1999 | AT 229703 T | 15-12-2002 |
| | | CA 2300306 A1 | 18-02-1999 |
| | | DE 19734722 A1 | 25-02-1999 |
| | | EP 1002353 A2 | 24-05-2000 |
| | | JP 2001512956 A | 28-08-2001 |
| | | WO 9908357 A2 | 18-02-1999 |
| DE 102007049251 A1 | 23-04-2009 | CN 101897098 A | 24-11-2010 |
| | | DE 102007049251 A1 | 23-04-2009 |
| | | DK 2198497 T3 | 24-08-2020 |
| | | EP 2198497 A2 | 23-06-2010 |
| | | US 2010276930 A1 | 04-11-2010 |
| | | WO 2009049822 A2 | 23-04-2009 |
| DE 102011121362 A1 | 20-06-2013 | DE 102011121362 A1 | 20-06-2013 |
| | | EP 2639955 A2 | 18-09-2013 |
| WO 2008049541 A1 | 02-05-2008 | CA 2667229 A1 | 02-05-2008 |
| | | CN 101606298 A | 16-12-2009 |
| | | DE 102006050077 A1 | 08-05-2008 |
| | | DK 2087571 T3 | 13-03-2017 |
| | | EP 2087571 A1 | 12-08-2009 |
| | | ES 2617860 T3 | 20-06-2017 |
| | | US 2010001527 A1 | 07-01-2010 |
| | | WO 2008049541 A1 | 02-05-2008 |

EPO FORM P0461

Für nähere Einzelheiten zu diesem Anhang : siehe Amtsblatt des Europäischen Patentamts, Nr.12/82

Seite 1 von 2

**ANHANG ZUM EUROPÄISCHEN RECHERCHENBERICHT
ÜBER DIE EUROPÄISCHE PATENTANMELDUNG NR.**

EP 20 20 1076

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-03-2021

| Im Recherchenbericht angeführtes Patentdokument | Datum der Veröffentlichung | Mitglied(er) der Patentfamilie | Datum der Veröffentlichung |
|---|---|---|---|
| ------------------------------------------------------------------------------------------ | | | |

Für nähere Einzelheiten zu diesem Anhang : siehe Amtsblatt des Europäischen Patentamts, Nr.12/82

EPO FORM P0461

Seite 2 von 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19734722 A1
- DE 102015112155 A1
- CA 2300306 A1